**Europäisches Patentamt**

**European Patent Office**

**Office européen des brevets**

(19)

(11) Veröffentlichungsnummer: **0 009 100**
A1

(12) **EUROPÄISCHE PATENTANMELDUNG**

(21) Anmeldenummer: 79102735.2

(22) Anmeldetag: 31.07.79

(51) Int. Cl.³: **G 11 C 27/02, H 03 H 15/02**

(30) Priorität: 31.08.78 DE 2838097

(43) Veröffentlichungstag der Anmeldung: 02.04.80
Patentblatt 80/7

(84) Benannte Vertragsstaaten: **BE FR GB IT NL**

(71) Anmelder: **SIEMENS AKTIENGESELLSCHAFT Berlin
und München, Postfach 22 02 61, D-8000
München 22 (DE)**

(72) Erfinder: **Pfleiderer, Hans-Jörg, Dr., Franz-Krinninger-
Weg 23, D-8011 Zorneding (DE)**
Erfinder: **Knauer, Karl, Dipl.-Ing., Am Dachsberg 13,
D-8011 Kirchseeon (DE)**

(54) Ladungsverschiebeanordnung und Verfahren zu ihrem Betrieb.

(57) Die Erfindung bezieht sich auf ein Verfahren zum Betrieb einer Ladungsverschiebeanordnung (CTD). Um einen möglichst hohen Signal-Rausch-Abstand des Ausgangssignals zu erreichen, wird die Ausgangsstufe (11–23) der Ladungsverschiebeanordnung mit einer in bezug auf die CTD-Taktfrequenz so niedrigen Frequenz ($\Phi_A$, $\Phi_B$) betrieben, daß mehrere Perioden der CTD-Taktfrequenz ($\Phi_1$–$\Phi_4$) in eine Ausleseperiode fallen. Dabei addieren sich die der Ausgangsstufe zugeführten, signalabhängigen Ladungsmengen arithmetisch, die zueinander nichtkorrelierten Rauschanteile geometrisch, so dass sich der Signal-Rausch-Abstand erhöht. Der Anwendungsbereich der Erfindung umfaßt insbesondere CTD-Transversalfilterschaltungen, die in System mit unterschiedlichen Taktfrequenzen eingesetzt sind.

BEZEICHNUNG GEÄNDERT
siehe Titelseite

SIEMENS AKTIENGESELLSCHAFT          Unser Zeichen
Berlin und München                  VPA 78 P 7 1 0 4

## Verfahren zum Betrieb einer Ladungsverschiebeanordnung

Die Erfindung bezieht sich auf ein Verfahren zum Betrieb einer Ladungsverschiebeanordnung nach dem Oberbegriff des Patentanspruches 1 sowie auf eine in besonderer Weise ausgebildete Ladungsverschiebeanordnung zur Durchführung desselben.

Ladungsverschiebeanordnungen (CTD) nach dem Oberbegriff des Patentanspruches 1 und Verfahren zu ihrem Betrieb werden beispielsweise in dem Buch von Séquin und Tompsett, "Charge Transfer Devices", Academic Press, New York, 1975, insbesondere auf den Seiten 1 bis 18, 23 bis 34, 48 bis 50 und 52 bis 56 beschrieben. Fig. 3.16 auf Seite 55 zeigt hierbei eine Ausgangsstufe mit einem entgegengesetzt zu der Halbleiterschicht dotierten Gebiet und mit elektrischen Schaltern, die ein periodisches Rücksetzen dieses Gebietes auf ein Referenzpotential und ein Abtasten des Ausgangssignals bewirken.

St 1 Koe / 25.8.1978

Der Erfindung liegt die Aufgabe zugrunde, ein Verfahren der eingangs genannten Art anzugeben, bei dem der Signal-Rausch-Abstand (signal-to-noise-ratio) des Ausgangssignals möglichst groß ist. Das wird erfindungsgemäß durch die im kennzeichnenden Teil des Anspruchs 1 aufgeführten Maßnahmen erreicht.

Das Verfahren nach der Erfindung zeichnet sich insbesondere dadurch aus, daß ein großer Signal-Rausch-Abstand des Ausgangssignals lediglich durch eine besondere Bemessung der Frequenzen der der Ausgangsstufe zugeführten Taktspannungen relativ zu der Frequenz der den Verschiebeelektroden zugeführten Taktspannungen sowie durch eine besondere Phasenlage der der Ausgangsstufe zugeführten Taktspannungen relativ zueinander erzielt wird. Die eigentliche Ladungsverschiebeanordnung wird hierdurch strukturell nicht beeinflußt, wenn man davon absieht, daß die Ausgangsstufe so dimensioniert werden muß, daß die ihr innerhalb einer Ausleseperiode mit der CTD-Taktfrequenz zugeführten, einzelnen Ladungsmengen sich zu einer das Ausgangssignal bestimmenden Summenladung addieren können.

Anspruch 2 gibt eine vorteilhafte Ausgestaltung des erfindungsgemäßen Verfahrens an, die Ansprüche 3 und 4 sind auf Ladungsverschiebeanordnungen gerichtet, die zur Durchführung des erfindungsgemäßen Verfahrens besonders geeignet sind.

Die Erfindung wird nachfolgend anhand der Zeichnung näher erläutert. Dabei zeigt:

Fig. 1 eine schematische Querschnittsdarstellung einer zur Durchführung des Verfahrens nach der Erfindung geeigneten Ladungsverschiebeanordnung, und

Fig. 2 Spannungs-Zeit-Diagramme zur Erläuterung des erfindungsgemäßen Verfahrens.

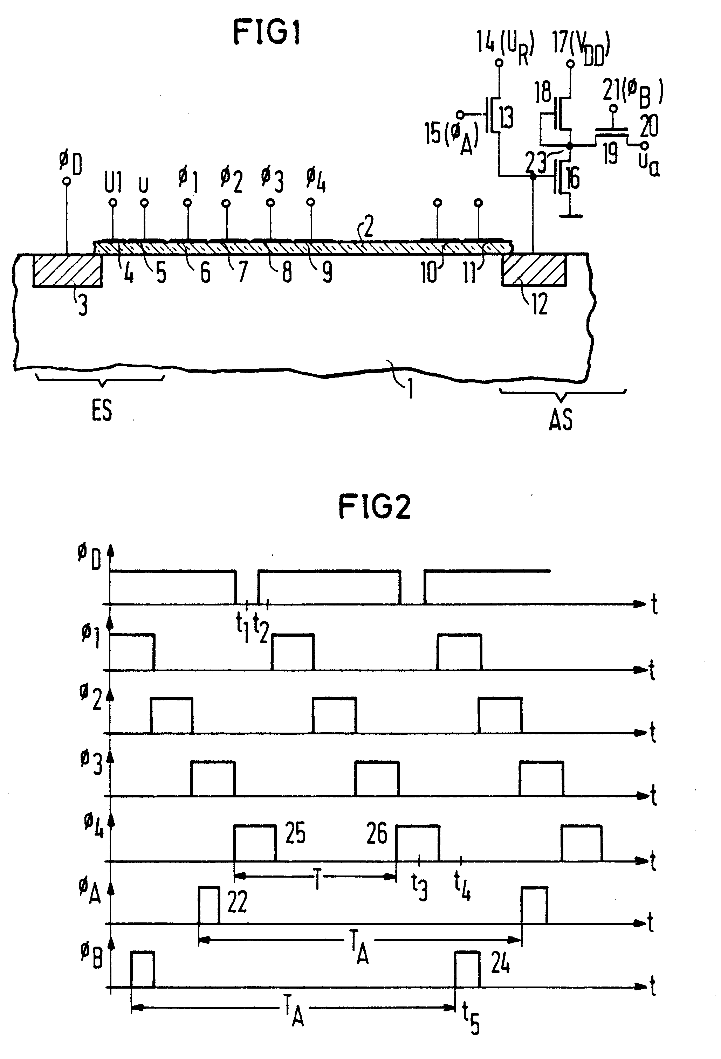

In Fig. 1 ist eine Ladungsverschiebeanordnung (CTD) in Form einer ladungsgekoppelten Anordnung (CCD) dargestellt, die in bzw. auf einer Halbleiterschicht 1 aus dotiertem Halbleitermaterial eines vorgegebenen Leitungstyps, z.B. aus p-leitendem Silizium, vorgesehen ist. Die Halbleiterschicht 1 kann dabei aus einer Epitaxialschicht bestehen, die auf einem Halbleitersubstrat oder einem Trägerkörper aus elektrisch isolierendem Material aufgewachsen ist, oder als Teil eines Halbleitersubstrats größerer Dicke aufgefaßt werden, das dann selbst den Trägerkörper bildet. Die Halbleiterschicht 1 ist mit einer dünnen elektrisch isolierenden Schicht 2 abgedeckt, die z.B. aus $SiO_2$ besteht. Mit 3 ist ein Gebiet entgegengesetzter Leitfähigkeit, also im angegebenen Beispiel ein n-leitendes Gebiet, bezeichnet, das durch eine Umdotierung der Halbleiterschicht 1 mittels einer Diffusion oder einer Implantation von Störstellenatomen hergestellt ist.

Auf der isolierenden Schicht 2 sind eine Reihe von nebeneinanderliegenden Elektroden 4 bis 11 angeordnet, die aus elektrisch leitenden Belegungen bestehen, z.B. aus einem Metall, insbesondere Al, oder aus hochdotiertem, polykristallinem Silizium. Die Elektroden 4 und 5 stellen jeweils ein erstes Eingangsgate und ein zweites Eingangsgate dar, die über ihre gezeigten Anschlüsse mit einer konstanten Gleichspannung U1 und einem analogen Eingangssignal u beschaltet sind. Das Gebiet 3 wird über seinen dargestellten Anschluß mit einer Taktspannung $\emptyset_D$ beaufschlagt. Die Teile 3 bis 5 bilden dabei die Eingangsstufe ES der ladungsgekoppelten Anordnung.

An die Eingangsstufe ES schließen sich die Elektroden 6 bis 11 an, von denen die Elektroden 6 bis 10 als Verschiebeelektroden bezeichnet werden. Im dargestellten Fall einer Vier-Phasen-Anordnung sind jeweils vier aufeinanderfolgende Verschiebeelektroden zu einer Stufe zusammengefaßt und über ihre Anschlüsse mit jeweils einer von vier gegeneinander phasenverschobenen Verschiebetaktspannungen $\emptyset_1$, $\emptyset_2$, $\emptyset_3$ und $\emptyset_4$ beschaltet. Die Verschiebeelektrorden 6 bis 8 gehören dabei zur ersten Stufe der ladungsgekoppelten Anordnung,während 10 die letzte Verschiebeelektrode der letzten Stufe bedeutet. Die Elektrode 11 bildet ein Ausgangsgate, das mit einer konstanten Gleichspannung U2 beschaltet ist.

Neben der Elektrode 11 ist eine Ausgangsstufe AS vorgesehen, die im vorliegenden Beispiel ein Diffusionsgebiet 12 mit einer zu 1 entgegengesetzten Leitfähigkeit aufweist. Das Diffusionsgebiet 12 ist über die Source-Drain-Strecke eines Feldeffekttransistors 13 an einen Anschluß 14 geführt, der mit einer Referenzspannung $U_R$ beschaltet ist. Das Gate von 13 ist mit einem Anschluß 15 verbunden, der mit einer Taktspannung $\emptyset_A$ beschaltet ist. Zusätzlich ist das Gebiet 12 mit dem Gate eines Feldeffekttransistors 16 verbunden, dessen Source-Drain-Strecke in einem Stromkreis liegt, der einerseits an einen die Versorgungsspannung $V_{DD}$ zuführenden Anschluß 17 und andererseits an das Massepotential geführt ist. Zwischen dem Drainanschluß des Feldeffekttransistors 16 und dem Schaltungspunkt 17 ist ein Lastelement 18 vorgesehen, das in Fig. 1 als Feldeffekttransistor realisiert ist, dessen Gate mit seinem Sourceanschluß verbunden ist. Der Verbindungspunkt zwischen dem Drainanschluß des Feldeffekttransistors 16 und dem Lastelement 18 ist über die Source-Drain-Strecke eines Feldeffekttransistors 19 mit einem Anschluß 20 verbunden, an dem das Ausgangssignal $u_a$ der Ladungsverschiebeanordnung abgreifbar ist. Das Gate des Transistors 19 ist über einen Anschluß 21 mit einer Taktspannung $\emptyset_B$ beschaltet.

Wie z.B. aus Fig. 3.12 (d) auf Seite 49 des obengenannten Buches von Séquin und Tompsett entnehmbar ist, wird die konstante Gleichspannung U1 so gewählt, daß sich unterhalb des Eingangsgate 4 eine feste Potentialschwelle ergibt. Über diese gelangen zum Zeitpunkt $t_1$ (Fig. 2), wenn das Potential des Gebietes 3 auf einen sehr niedrigen Wert abgesenkt worden ist, Ladungsträger aus dem Gebiet 3 in die unter dem Einfluß des Eingangssignals u unterhalb des Eingangsgate 5 aufgebaute Potentialsenke. Wird das Potential des Gebietes 3 zum Zeitpunkt $t_2$ wieder erhöht, so fließt ein Teil der Ladungsträger aus der Potentialsenke unterhalb von 5 wieder in das Gebiet 3 zurück, wobei die Differenz zwischen der Potentialschwelle unterhalb des Eingangsgate 4 und dem Potentialmaximum unterhalb von 5, welches von dem Momentanwert des Eingangssignals u abhängig ist, die in der Potentialsenke verbleibende Ladungsmenge bestimmt. Unter dem Einfluß der Taktspannungen $\phi_1$ bis $\phi_4$ wird dann die in der Potentialsenke befindliche, signalabhängige Ladungsmenge aus dieser entnommen und schrittweise in dem unterhalb der Reihe der Elektroden 6 bis 10 liegenden CCD-Kanal in Richtung auf die Ausgangsstufe AS verschoben.

Der vorstehend beschriebene Einlesevorgang wiederholt sich mit der Frequenz der Taktspannung $\phi_D$, wobei die periodisch eingelesenen Ladungsmengen in einem gegenseitigen Abstand, der dem vierfachen Elektrodenabstand entspricht, von Stufe zu Stufe transportiert werden. Innerhalb jeder Periode T der Taktspannungen $\phi_1$ bis $\phi_4$, die mit der Taktspannung $\phi_D$ frequenzgleich sind, durchlaufen sie dabei den Halbleiterbereich unterhalb von vier aufeinanderfolgenden Verschiebeelektroden.

Ist eine der verschobenen Ladungsmengen unterhalb von der Verschiebeelektrode 10 angelangt ($t_3$), so wird sie nach Beendigung des Taktimpulses von $\phi_4$ wegen des dann

($t_4$) wieder auf einen kleinen Wert abgesenkten Potentials unterhalb von 10 über eine feste Potentialschwelle, die unterhalb des Ausgangsgate 11 durch U2 entsteht, in das Gebiet 12 transportiert. Das Gebiet 12 befindet sich vor dem Eindringen der Ladungsmenge auf einem Referenzpotential $U_R$, auf das es durch Umschalten des Transistors 13 in den leitenden Zustand während des Auftretens eines Impulses 22 der seinem Gate 15 zugeführten Taktspannung $\phi_A$ rückgesetzt wird. Nach Beendigung des Impulses 22 ist das Gebiet 12 von äußeren Potentialen freigeschaltet, wobei es sich in einem Zustand befindet, der auch als "floating" bezeichnet wird. Durch das Eindringen der verschobenen, signalabhängigen Ladungsmenge in das Gebiet 12 wird dessen Potential und damit das Potential am Gate des Transistors 16 entsprechend abgesenkt, was durch die Wirkung des aus den Elementen 16 und 18 bestehenden Inverters zu einer Potentialerhöhung am Schaltungspunkt 23 führt. Das an 23 abgreifbare Signal wird dann durch die Funktion des Transistors 19, der während des Auftretens des Impulses 24 der Taktspannung $\phi_B$ in den leitenden Zustand geschaltet wird, zum Zeitpunkt $t_5$ abgetastet und als Ausgangssignal $u_a$ an den Ausgang 20 übertragen.

Das Rücksetzen des Gebietes 12 und die Abtastung des bei 23 auftretenden Signals mittels des Transistors 19 erfolgt jeweils periodisch mit einer Periode $T_A$, die in Fig. 2 eingezeichnet ist. Die Frequenz der Taktspannungen $\phi_A$ und $\phi_B$ ist nach der Erfindung in bezug auf die Frequenz der Taktspannungen $\phi_1$ bis $\phi_4$ und $\phi_D$ so niedrig gewählt, daß die Ausleseperiode $T_A$ mehrere Perioden $T$ der Taktspannungen $\phi_1$ bis $\phi_4$ und $\phi_D$ umfaßt. In den Diagrammen der Fig. 2 stehen die Perioden $T$ und $T_A$ im Verhältnis von 1:2. Im Rahmen der Erfindung ist das Verhältnis zwischen $T$ und $T_A$ ganz allgemein so zu wählen, daß zwei oder mehrere Perioden $T$ von einer

0009100

Periode $T_A$ umfaßt werden, wobei das Größenverhältnis nicht unbedingt einen rationalen Wert haben muß. Letzteres ist allerdings zweckmäßig, da sich die unterschiedlichen Frequenzen der einzelnen Taktspannungen dann aus einer gemeinsamen Frequenz über frenzteilende oder -vervielfachende Mittel ableiten lassen.

Wenn der die Relation zwischen den Perioden T und $T_A$ herstellende Faktor mit m bezeichnet wird, ist für eine Betriebsweise entsprechend Fig. 2 m=2 zu setzen, da hier $T_A$=2·T gilt. In diesem Fall baut sich nach einem vorherigen Rücksetzen des Gebietes 12 auf das Referenzpotential $U_R$ während des Auftretens des Impulses 22 in diesem Gebiet eine Summenladung auf, die aus zwei Ladungsmengen besteht, welche jeweils nach Beendigung der Impulse 25 und 26 über die Schwelle unterhalb des Ausgangsgate 11 eingebracht werden. Die von der Summenladung am Schaltungspunkt 23 hervorgerufene Potentialänderung wird dann zum Zeitpunkt $t_5$ mittels des Transistors 19 abgetastet und als Ausgangssignal $u_a$ dem Ausgang 20 zugeführt. Wie aus Fig. 2 ersichtlich, ist der Impuls 24 von $\emptyset_B$ in seiner Phase gegenüber dem Impuls 22 von $\emptyset_A$ soweit verschoben, daß die Impulse 25 und 26 in dem von 24 und 22 begrenzten Zeitintervall liegen.

Wesentlich ist hierbei, daß die Amplitude des Ausgangssignals $u_a$ bei dem erfindungsgemäßen Verfahren gegenüber dem Fall, bei dem die Frequenzen aller Taktspannungen gleich groß sind, um den Faktor m erhöht ist, während die Rauschanteile des Ausgangssignals sich nur um den Faktor $\sqrt{m}$ vergrößern. Dies ist darauf zurückzuführen, daß die einzelnen Ladungsmengen, die sich innerhalb einer Periode $T_A$ in dem Gebiet 12 aufaddieren, zueinander korreliert sind, so daß sie arithmetisch addiert werden können, während die Rauschanteile des Ausgangssignals, die auf in der Eingangsstufe ES, in den einzelnen Stufen des CCD und in der Ausgangsstufe AS vorhandene Rauschquellen zurückzuführen sind, zueinander nicht korreliert sind, so daß sie in der Weise addiert werden müssen, daß die Quadratwurzel aus der Summe der den einzelnen Ladungsmengen zugeordneten, quadrierten Rauschsignalanteile gebildet werden muß. Damit wird jedoch das Signal-Rausch-Verhältnis des Ausgangssignals $u_a$ gegenüber dem herkömmlichen Betriebsverfahren, bei dem die Frequenzen aller zugeführten Taktspannungen gleich groß sind, wesentlich vergrößert.

Die Größe des Gebietes 12 der in Fig. 1 dargestellten Ladungsverschiebeanordnung wird so bemessen, daß die an seiner Grenzfläche vorhandene Sperrschichtkapazität gegenüber der Halbleiterschicht 1 beim Anlegen des Referenzpotentials $U_R$ sämtliche Ladungsmengen aufnehmen kann, die innerhalb einer Ausleseperiode $T_A$ eindringen.

Obwohl die zur Durchführung des Verfahrens nach der Erfindung dienende Ladungsverschiebeanordnung bisher lediglich als eine CCD-Anordnung gemäß Fig. 1 beschrieben wurde, kann auch irgendeine der unter dem Begriff Ladungsverschiebeanordnung (CTD) zusammengefaßte, an sich bekannte Anordnung hierfür herangezogen werden, wie sie z.B. in dem eingangs erwähnten Buch von Séquin und Tompsett auf den Seiten 1 bis 18 behandelt ist. Eine solche Ladungsverschiebeanordnung kann dabei entsprechend ihrem Aufbau im Zwei-, Drei-, Vier- oder Mehrphasen-Betrieb arbeiten. Sie kann auch einen Bestandteil eines CTD-Transversalfilters darstellen, bei dem ein großes Signal-Rausch-Verhältnis des Ausgangssignals für die Erreichung der gewünschten Filtereigenschaften besonders wichtig ist.

5 Patentansprüche
2 Figuren

C009100

- 1 -     VPA

78 P 7 1 0 4

<u>Patentansprüche</u>

1. Verfahren zum Betrieb einer Ladungsverschiebeanordnung, die eine Halbleiterschicht, eine diese abdeckende, dünne, elektrisch isolierende Schicht, eine Reihe von auf der letzteren nebeneinander angeordneten Verschiebeelektroden, eine Eingangsstufe und eine Ausgangsstufe aufweist, bei dem von der Eingangsstufe Ladungsmengen, die diskreten Amplitudenwerten eines Eingangssignals entsprechen, periodisch in die Halbleiterschicht injiziert werden, bei dem die injizierten Ladungsmengen mittels erster Taktspannungen einer vorgegebenen Taktfrequenz, die an die Verschiebeelektroden gelegt sind, schrittweise in Richtung der Ausgangsstufe verschoben werden und bei dem ein Schaltungspunkt der Ausgangsstufe innerhalb von Ausleseperioden jeweils zunächst mittels eines von einer zweiten Taktspannung kontrollierten Schalters auf ein Referenzpotential zurückgesetzt wird, worauf ein dort abgegriffenes Ausgangssignal, das von der der Ausgangsstufe zugeführten Ladungsmenge abhängig ist, mittels eines weiteren, von einer dritten Taktspannung kontrollierten Schalters abgetastet wird, d a d u r c h   g e k e n n z e i c h n e t ,   daß die untereinander gleichen Frequenzen der zweiten ($\emptyset_A$) und dritten Taktspannung ($\emptyset_B$) im Vergleich zu der vorgegebenen Taktfrequenz so niedrig gewählt sind, daß jede Ausleseperiode ($T_A$) mehrere Perioden (T) der ersten Taktspannungen ($\emptyset_1$ bis $\emptyset_4$) umfaßt und daß die zweite ($\emptyset_A$) und dritte Taktspannung ($\emptyset_B$) in der Phase derart gegeneinander verschoben sind, daß sich jeweils mehrere innerhalb einer Ausleseperiode ($T_A$) der Ausgangsstufe (AS) zugeführten Ladungsmengen zu einer das Ausgangssignal ($u_a$) bestimmenden Summenladung addieren.

2. Verfahren nach Anspruch 1, d a d u r c h
g e k e n n z e i c h n e t , daß die Taktfrequenz
der ersten Taktspannungen ($\emptyset_1$ bis $\emptyset_4$) ein ganzzahliges
Vielfaches der Frequenz der zweiten ($\emptyset_A$) und dritten
Taktspannung ($\emptyset_B$) darstellt.

3. Ladungsverschiebeanordnung zur Durchführung des
Verfahrens nach Anspruch 1 oder 2, mit einer Ausgangsstufe, die ein durch den Schalter periodisch auf ein
Referenzpotential zurücksetzbares, entgegengesetzt zu
der Halbleiterschicht dotiertes Gebiet aufweist,
d a d u r c h  g e k e n n z e i c h n e t , daß das
Gebiet (12) so groß bemessen ist, daß seine Sperrschichtkapazität gegenüber der Halbleiterschicht (1)
die sich innerhalb einer Ausleseperiode ($T_A$) ergebende
Summenladung aufnimmt.

4. Ladungsverschiebeanordnung nach Anspruch 3,
g e k e n n z e i c h n e t  durch ein zwischen den
Verschiebeelektroden (6...10) und dem entgegengesetzt
zu der Halbleiterschicht (1) dotierten Gebiet (12) auf
der elektrisch isolierenden Schicht (2) angeordnetes
Ausgangsgate (11), das mit einer konstanten Gleichspannung (U2) beschaltet ist.

5. Ladungsverschiebeanordnung nach einem der Ansprüche
2 oder 4, d a d u r c h  g e k e n n z e i c h n e t ,
daß sie einen Bestandteil eines Transversalfilters
bildet.

FIG1

FIG2

Europäisches Patentamt

**EUROPÄISCHER RECHERCHENBERICHT**

0009100

Nummer der Anmeldung

EP 79 10 3735

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | BE - A - 861 098 (ORGANISATION EUROPEENNE DE RECHERCHES SPATIALES)<br><br>* Seite 4, Zeile 27 - Seite 6, Zeile 9; Figuren 3,4 *<br><br>---- | 1,2 | G 11 C 27/02<br>H 03 H 15/02 |

**RECHERCHIERTE SACHGEBIETE (Int. Cl. 3)**

G 11 C 27/02
H 03 H 15/02

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 04-12-1979 | DEGRAEVE |

EPA form 1503.1    06.78